Europäisches Patentamt

European Patent Office

Office européen des brevets

(11) Publication number: **0 264 569 B1**

# EUROPEAN PATENT SPECIFICATION

(45) Date of publication of patent specification: **04.03.92**   (51) Int. Cl.⁵: **C04B 33/30**

(21) Application number: **87111963.2**

(22) Date of filing: **18.08.87**

(54) **Method for reducing edge curl on green sheets.**

(30) Priority: **24.10.86 US 923060**

(43) Date of publication of application:
**27.04.88 Bulletin  88/17**

(45) Publication of the grant of the patent:
**04.03.92 Bulletin  92/10**

(84) Designated Contracting States:
**DE FR GB IT**

(56) References cited:
**DD-A- 134 080**
**DD-A- 241 251**

(73) Proprietor: **International Business Machines Corporation**
**Old Orchard Road**
**Armonk, N.Y. 10504(US)**

(72) Inventor: **Kellner, Benedikt Maria Johannes**
**RD. 3 Rte 376**
**Wappingers Falls N.Y. 12590(US)**
Inventor: **Scilla, Salvatore James**
**Warren Street**
**Marlboro, N.Y. 12542(US)**

(74) Representative: **Colas, Alain**
**Compagnie IBM France Département de Propriété Intellectuelle**
**F-06610 La Gaude(FR)**

## Description

The present invention relates primarily to the field of manufacturing of semiconductor devices and particularly to the field of producing unfired ceramic sheets, used in making ceramic substrates, which can be processed by automated equipment.

In the manufacture of ceramic sheets for use in making VLSI circuits, a slurry is first made which consists of ceramic particles such as alumina or glass particles which are suspended in an organic solution containing an organic binder including plasticizers. The slurry is then deposited in a thin layer on a backing web made, for example, of MYLAR material (MYLAR is a registered trademark of E.I. DuPont De Nemours & Co. of Wilmington, Delaware). The slurry on the web then passes under a forced air dryer to drive off the solvents in the slurry thereby leaving a thin layer about 0,125 to 0,75 mm in thickness) of unfired ceramic material embedded in a solid organic matrix.

The ceramic-containing layer is subsequently separated from the backing web and wound in the form of an unfired ceramic web onto a spool. Thereafter, the spooled unfired ceramic web is cut into small sheets which are preferably loaded into a cartridge which holds and separates a plurality of such sheets which are referred to as "green sheets", a generic term used to describe a ceramic sheet prior to firing or sintering.

It is well known that green sheets are unstable as has been noted, for example, in US-A 4.497.677 and 4.340.436. Indeed, a frequently encountered instability is that of edge curl. Green sheets frequently curl up at their edges primarily as a result of the forced air dryer for removing solvents from the slurry used in making the green sheets. The extent of curling which is experienced in green sheets is related to the particular ceramic material, the organic matrix in which the ceramic material is embedded, the particular solvents which are used to make up the slurry, and the speed with which the solvents are removed from the slurry.

The curl in green sheets, if it is large enough, can cause problems with certain types of automated equipment designed for handling such green sheets. For example, a machine designed to cut the rolled unfired ceramic web into sheets has been found to be sensitive to edge curl in that the sheet transport does not work well with sheets having an edge curl greater than about 0,5 mm. Similar problems can occur with vacuum pickup mechanisms if the green sheet is not flat. Problems may also develop in green sheet punching if the sheet is not flat.

Various solutions have been suggested to solve the problem of edge curl on green sheets. As the edge curl is primarily caused by the speed at which solvents are removed from the slurry used in forming the web from which the green sheets are cut, one solution is to slow the speed at which the solvents are removed. This approach, however, has the disadvantage of slowing the manufacturing process used in forming the web thereby unnecessarily tying up expensive manufacturing equipment.

An alternative approach is to "iron" out the curl. In this approach, a weight is placed on the green sheets with edge curl. Then the temperature is raised for a period of time. The elevated temperature is not sufficiently high to cure the ceramic material but is sufficiently high to relax the stresses in the sheet. This approach, however, has been found to contribute to a decrease in screening stability of the sheet. Accordingly, this approach is not desirable, especially in components having high circuit density.

In view of the above mentioned problems, it is the principal objective of the present invention to provide a method for reducing edge curl in green sheets to acceptable levels so that the green sheets can be processed by automated processing equipment without difficulty.

It still a further objective of the present invention to provide a method for reducing edge curl in green sheets to acceptable levels so that the green sheets can be processed automatically and so that the green sheets will not have increased screening instability as a result of the edge curl reduction method.

The edge curl reduction method of the present invention involves first cutting sheets from the spooled web of uncured or unfired ceramic material. These sheets exhibit greater or lesser degree of edge curl, depending on the particular material involved and the manner in which the sheets are formed. The formed sheets are then placed in a tray, one on top of another. The tray is then placed in a chamber substantially at room temperature (about 22 degrees C) at approximately 90-95% relative humidity for a period of about 2 weeks or until the internal stresses in the green sheet have been relaxed. Thereafter, the tray is placed in a chamber at room temperature at approximately 35% relative humidity for a period of about a week or until substantially all the water picked up previously has been removed from the green sheet. Once dried, the sheets will exhibit significantly less edge curl than existed at the time of the beginning the process.

Green sheets, as already mentioned above, are used in the manufacture of multi-layer ceramic substrates which form a part of typical semiconductor devices currently being manufactured. As has already been noted, such green sheets quite frequently have edge curl which may inhibit the use of automated equipment to process the green sheets. The greater the edge curl that is present for a particular kind of green sheet, the more likely it is that automated equipment will experience problems using such green sheets.

In the case of the present invention, green sheets are cut into squares of about 18 cm on a side. The upper surface of the green sheet at its edge typically lies in a plane which is usually at least 0,25 mm higher than the plane in which the center of the upper surface of the green sheet lies. The height of the edge above the plane of the center can often be greater than 0,25 mm and may be as great as 2,5 mm or more above the plane of the center of the sheet. When the edge curl causes the edge to be at least about 0,25 mm above the plane of the center of a green sheet, it is quite likely that some automated equipment for handling such green sheets is likely to malfunction in processing such green sheets. This is particularly true of vacuum pickup devices which depend on the sheet to be very flat in order to work properly.

In accordance with the present invention, edge curl is reduced by treating the green sheets in the manner hereinafter described in greater detail. The green sheets are first cut into sheets which are about 18 cm square although the size is not particularly important to the present invention. However, the larger the green sheet, the more likely that edge curl will create a handling problem for some automated handling equipment.

The cut green sheets are first stacked in a tray. The bottom-most green sheet rests on a protective sheet which, in the preferred embodiment of the invention, is made of Kimdura material which prevents contact with the tray (Kimdura is a registered trademark of Kimberly-Clark Corporation). The protective sheet is very smooth and does not itself scratch the green sheet in contact therewith. The protective sheet also helps to keep the green sheets clean. A second protective sheet made of the same material as the first protective sheet is placed over the top of the green sheets in the tray to protect the upper-most green sheet from contamination. The exact material used for the protective sheet at the top and bottom of the stack of green sheets is not critical. This protective sheet is merely to protect the top and bottom green sheets from being scratched or contaminated due to contact with a contaminating substance.

The tray, in the preferred embodiment has a base on which the Kimdura material sheet rests and the green sheets rest thereon. Around the perimeter of the base are a plurality of posts which extend upwardly from the base and provide a means for keeping the stack of green sheets in place. The posts extend upwardly a distance which is greater than the height of the stack of green sheets plus the two Kimdura material sheets the tray is designed to carry. This provides a measure of protection for the green sheets in the tray as trays can be stacked one on top of another without causing damage to the green sheets already in a tray. In the preferred embodiment, the trays are designed to carry about 40 green sheets, one resting on top of another.

Once the green sheets with edge curl are placed in a tray, the trays are stacked in a treatment chamber where the temperature and relative humidity is precisely controlled within a specified tolerance range. In the present invention, the temperature of the chamber is maintained at 22 degrees C plus or minus 2 degrees C. The relative humidity in the chamber is also controlled very closely. The relative humidity is specified as 92% plus 3% and minus 2%. The trays are maintained at the specified temperature and humidity for a period of about two weeks which has been found to be sufficient to saturate with water sheets made of a glass ceramic material. If a different material is involved, the time required for the green sheets to become saturated may be different. It is also possible to achieve substantially the same results by keeping the green sheets in a controlled environment for a time less than that required to become saturated. The time required, however, is that which will result in substantially relaxing the internal stresses within the green sheets. This can only be measured by placing the green sheets in the high humidity treatment and subsequently drying the green sheet slowly and measuring the resulting edge curl. If the resulting edge curl is within the design tolerance, then the selected high humidity treatment time was sufficient. If the resulting edge curl is too great, then a longer time is required to relax the stresses in the green sheet.

The moisture picked up by the green sheets during the processing set forth above usually causes the green sheet to become limp due to its having become substantially saturated with water. Accordingly, subsequent processing of green sheets in this form is not possible. The green sheets must then be dried out in a manner which does not reintroduce edge curl which appears to have been created in the rapid drying of the slurry used in making the green sheet in the first place. In the present invention, drying of the substantially saturated sheets is accomplished by placing the trays in a chamber which is also maintained at about room temperature (22 degrees C plus or minus 2 degrees C). The humidity in the chamber is maintained at 35% relative humidity plus or minus 5%. The green sheets are maintained in that environment until substantially all the water which could be removed by such a treatment has been removed. In a typical application of the present method, this time period is about 1 week. Once removed from the lower humidity treatment, the green sheets can be measured for edge curl, and if the treatment parameters have been proper for the particular green sheet composition, the edge curl measured will be small enough that it is no longer a problem for automated processing machines to handle such green sheets.

The effectiveness of the above described method for treating green sheets is quite evident from the test results. Typically, edge curl in certain untreated glass ceramic sheets is in the order of about 2,5 mm which does give rise to severe problems in automatic handling of such green sheets subsequent to cutting the sheets. After proper treatment, however, edge curl is reduced to below 0,25 mm which, for most processing equipment, is sufficiently flat that automated processing equipment can move such green sheets without becoming jammed or failing to pick up a green sheet that should be moved to another processing station.

## Claims

1. A process for reducing edge curl in a ceramic green sheet characterized in that it comprises the steps of:

   a) placing at least one said green sheet into a treatment chamber maintained at substantially room temperature and a high relative humidity for a sufficient time to relax the stresses in the green sheets placed in said chamber; and

   b) placing said treated green sheets in a controlled environment at substantially room temperature at a humidity lower than said high humidity of step a) for a period of time required to remove from the green sheet the excess water picked up during step a) to thereby cause the green sheet to become sufficiently rigid and free of edge curl that subsequent machine handling of the green sheet by automated equipment is not hindered by the form of the sheet itself.

2. The process of Claim 1 wherein said selected temperature in said high humidity and said lower humidity is between 20° and 24°C.

3. The process of Claim 1 or 2 wherein said selected temperature is defined as substantially 22°C.

4. The process of Claim 1, 2 or 3 wherein said time of treatment in said high humidity comprises at least 336 hours.

5. The process according to anyone of the preceding Claims wherein said processing time in said lower humidity is at least 168 hours.

6. The process according to anyone of the preceding Claims wherein said high humidity comprises between 90% and 95% relative humidity.

7. The process according to anyone of the preceding Claims wherein said lower humidity comprises between 30 and 40% relative humidity.

8. The process according to anyone of the preceding Claims wherein said lower humidity comprises substantially the relative humidity in which processing of the green sheet subsequent to edge curl removal occurs.

## Revendications

1. Procédé de réduction de bordage d'une plaque céramique crue, caractérisé en ce qu'il comprend les phases suivantes :

   a) mise en place d'au moins une plaque crue dans une chambre de traitement, maintenue pratiquement à la température ambiante et avec une humidité relativement élevée, pendant une durée suffisante pour détendre les contraintes à l'intérieur des plaques crues placées dans ladite chambre, et

   b) mise en place desdites plaques crues traitées dans un milieu contrôlé, pratiquement à la température ambiante et avec une humidité inférieure à ladite humidité élevée de la phase a), pendant une durée nécessaire à éliminer de la plaque crue l'excès d'eau capté pendant la phase a), pour rendre ainsi la plaque crue suffisamment rigide et exempte de bordage, de manière à ce que le traitement mécanique ultérieur de la plaque crue au moyen d'un appareil automatique ne soit pas entravé par la forme de la feuille proprement dite.

2. Procédé selon la revendication 1, caractérisé en ce que la température choisie pour l'humidité élevée et l'humidité réduite est comprise entre 20 et 24°C.

3. Procédé selon la revendication 1 ou 2, caractérisé en ce que la température choisie est sensiblement de 22°C.

4. Procédé selon la revendication 1, 2, ou 3, caractérisée en ce que la durée du traitement à humidité élevée est d'au moins 336 heures.

5. Procédé selon l'une quelconque des revendications précédentes, caractérisé en ce que la durée du traitement à humidité réduite est d'au moins 168 heures.

6. Procédé selon l'une quelconque des revendications précédentes, caractérisé en ce que l'humidité élevée comprend entre 90 et 95 % d'humidité relative.

7. Procédé selon l'une quelconque des revendications précédentes, caractérisé en ce que l'humidité réduite comprend entre 30 et 40 % d'humidité relative.

8. Procédé selon l'une quelconque des revendications précédentes, caractérisé en ce que l'humidité réduite comprend sensiblement l'humidité relative à laquelle s'effectue le traitement de la plaque crue, aussitôt après l'élimination du bordage.

**Patentansprüche**

1. Verfahren zum Verringern einer Randaufbiegung bei einer keramischen Rohplatte, dadurch gekennzeichnet, daß es die folgenden Schritte umfaßt:

   a) Einbringen zumindest einer Rohplatte in eine Behandlungskammer, die im wesentlichen bei Raumtemperatur und einer großen relativen Feuchtigkeit für eine hinreichende Zeit gehalten wird, damit die Spannungen in den in die Kammer eingebrachten Rohplatten nachlassen und
   b) Einbringen der behandelten Rohplatten in eine regulierte Umgebung im wesentlichen bei Raumtemperatur bei einer kleineren Feuchtigkeit als die große Feuchtigkeit bei Schritt a) für eine Zeitdauer, die zum Entfernen des während des Schrittes a) gesammelten Überschußwassers von der Rohplatte erforderlich ist, um dadurch zu bewirken, daß die Rohplatte ausreichend starr und frei von einer Randaufbiegung wird, daß eine nachfolgende Maschinenbehandlung der Rohplatte durch eine automatisierte Einrichtung durch die Form der Platte nicht gehindert wird.

2. Verfahren nach Anspruch 1, bei welchem die ausgewählte Temperatur bei der großen Feuchtigkeit und der kleineren Feuchtigkeit zwischen 20° und 24° C liegt.

3. Verfahren nach Anspruch 1 oder 2, bei welchem die ausgewählte Temperatur im wesentlichen als 22° C definiert ist.

4. Verfahren nach Anspruch 1, 2 oder 3, bei welchem die Behandlungszeit bei der großen Feuchtigkeit zumindest 336 Stunden beträgt.

5. Verfahren nach irgendeinem der vorigen Ansprüche, bei welchem die Bearbeitungszeit bei der kleineren Feuchtigkeit zumindest 168 Stunden beträgt.

6. Verfahren nach irgendeinem der vorigen Ansprüche, bei welchem die große Feuchtigkeit eine relative Feuchtigkeit zwischen 90% und 95% umfaßt.

7. Verfahren nach irgendeinem der vorigen Ansprüche, bei welchem die kleinere Feuchtigkeit eine relative Feuchtigkeit zwischen 30% und 40% umfaßt.

8. Verfahren nach irgendeinem der vorigen Ansprüche, bei welchem die kleinere Feuchtigkeit im wesentlichen die relative Feuchtigkeit umfaßt, bei welcher eine Bearbeitung der Rohplatte nach einer Randaufbiegungsentfernung erfolgt.